# FASCICULE DE BREVET EUROPEEN

(11) **EP 0 409 897 B1**
(45) Date de publication et mention de la délivrance du brevet: **08.09.1993**
(21) Numéro de dépôt: 89905130.4
(22) Date de dépôt: 14.04.1989
(51) Int. Cl.: C30B 23/06, C30B 23/02, C30B 29/48

(54) **DISPOSITIF D'ALIMENTATION A NIVEAU CONSTANT D'UNE CELLULE D'EVAPORATION DE MERCURE POUR EPITAXIE**
VORRICHTUNG FÜR DIE ZUFÜHRUNG VON QUECKSILBER AUF GLEICHBLEIBENDER HÖHE IN EINE VERDAMPFUNGSZELLE FÜR EPITAXIE
CONSTANT LEVEL SUPPLY OF A MERCURY EVAPORATION CELL FOR EPITAXY

(30) Priorité: 15.04.1988 FR 8805044
(43) Date de publication de la demande: 30.01.1991
(73) Titulaire: RIBER Société Anonyme, F-92503 Rueil-Malmaison Cedex (FR)
(72) Inventeur: BARSKI, André, F-93500 Pantin (FR); BOUCHAIB, Pierre, F-78420 Carrières-sur-Seine (FR); HERBIN, Michel, F-78112 Fourqueux (FR); LANSADE, Christian, F-95100 Argenteuil (FR); LECLERC, Alain, F-78800 Houilles (FR)
(74) Mandataire: Phélip, Bruno
(86) Numéro de dépôt international: FR8900171
(87) Numéro de publication internationale: WO8909847

(56) Documents cités:
- DE-C- 892 023
- FR-A- 2 568 545
- FR-A- 2 568 662
- GB-A- 2 156 231

## Description

La présente invention a pour objet un dispositif d'évaporation du mercure à niveau constant sous vide dans une cellule destinée à la croissance épitaxiale des semi-conducteurs, notamment ceux constitués par les éléments des groupes II à VI de la Classification Périodique, la combinaison de ces éléments étant désignée ici et dans ce qui suit semi-conducteurs II-VI.

On sait que les semi-conducteurs II-VI, tels que Hg, Cr, Te ont une importance considérable dans le domaine des applications militaires et des applications à venir dans la télécommunication par fibre optique fluorée. A l'heure actuelle, la croissance épitaxiale sous vide de ces semi-conducteurs représente une des techniques les plus avancées, qui exige pour sa mise en oeuvre la réalisation de dispositifs d'évaporation très performants. Jusqu'à présent le problème de l'alimentation en mercure d'une cellule à épitaxie par jet moléculaire n'avait pas été résolu de façon satisfaisante. On avait notamment proposé un système de vanne coopérant avec un soufflet. Un tel agencement présentait l'inconvénient d'un temps mort d'utilisation de la çellule au moment de sa recharge.

Par GB-A-2 156 231, on connait un dispositif permettant l'évaporation de liquides comme le mercure, pour le dépôt épitaxique par jet moléculaire. Ce dispositif connu comporte une cellule d'évaporation sous vide, associée à des moyens permettant le remplissage, la mise à niveau ou le vidage de mercure dans la cellule. La mise à niveau du liquide dans la cellule à partir d'un réservoir et par l'intermédiaire d'un tube d'alimentation, s'effectue par le principe des vases communicants.

Par ailleurs, on connait par DE-C-892 023, un dispositif d'alimentation, destiné à maintenir très précisément le niveau de liquide dans une cellule d'évaporation de liquide. Ce dispositif d'alimentation comprend un réservoir de liquide, déplaçable verticalement, et relié par un tube flexible à la cellule d'évaporation, la mise à niveau s'effectuant selon le principe des vases communicants.

Un objet de la présente invention est de fournir un dispositif permettant d'alimenter en mercure une cellule à épitaxie par jet moléculaire, tout en supprimant le système antérieur de vanne coopérant avec un soufflet, et par là même le temps mort d'utilisation de ladite cellule.

Un autre objet de la présente invention est de réaliser un dispositif facile à mettre en oeuvre et pouvant fonctionner soit manuellement soit de façon automatique.

La présente invention propose à cet effet un dispositif de croissance épitaxiale par jet moléculaire, comprenant une cellule d'évaporation de mercure dans un bâti de croissance sous vide, et un dispositif d'alimentation de cette cellule, le dispositif d'alimentation comportant lui-même :
- un réservoir d'alimentation en mercure,
- un tube d'alimentation de la cellule à partir du réservoir, et
- des moyens de remplissage, de mise à niveau et de vidange de mercure dans ladite cellule, et se caractérisant en ce que les moyens de remplissage, mise à niveau et vidange permettent le déplacement en translation verticale du réservoir, ce déplacement étant réalisé manuellement ou par l'intermédiaire de moyens moteurs, et ces moyens comprennent, au niveau de la liaison entre la cellule et le réservoir d'alimentation, un agencement de vannes permettant :
   -- de couper la communication entre le réservoir et la cellule pour le remplissage du réservoir,
   -- d'équilibrer les pressions entre le réservoir et le bâti de croissance de la cellule qui est toujours sous vide, et
   -- d'évacuer l'air de l'espace entre le tube d'alimentation de la cellule et un soufflet de protection de ce tube.

Dans une forme de réalisation particulière de l'invention, le réservoir est monté sur des moyens supports permettant au réservoir d'occuper diverses positions assurant un remplissage à niveau constant de la cellule.

La cellule d'évaporation selon l'invention est avantageusement pourvue d'une sonde de niveau de mercure émettant un signal traité par des moyens électro-informatiques et permettant de déclencher la mise en marche des moyens moteurs, de façon à permettre la remise à niveau du mercure dans la cellule. Cette cellule est munie d'une sonde de température disposée dans ladite cellule au voisinage immédiat du niveau d'évaporation du mercure, assurant ainsi une grande sensibilité de lecture de ladite température.

D'autres avantages et caractéristiques de la présente invention ressortiront de la description suivante d'une forme de réalisation non limitative du dispositif d'alimentation en mercure d'une cellule à épitaxie par jet moléculaire selon l'invention, en référence aux dessins annexés, dans lesquels :
Figure 1 est une vue latérale schématique, partiellement en coupe, du dispositif d'alimentation en mercure selon la présente invention en position telle que la cellule est vide;
Figure 2 est une vue analogue à la figure 1, mais avec le dispositif d'alimentation en position de mise à niveau du mercure dans la cellule, et
Figure 3 est une vue en coupe, à plus grande échelle, de la cellule d' évaporation du mercure à épitaxie par jet moléculaire, représentée sur les figures 1 et 2.

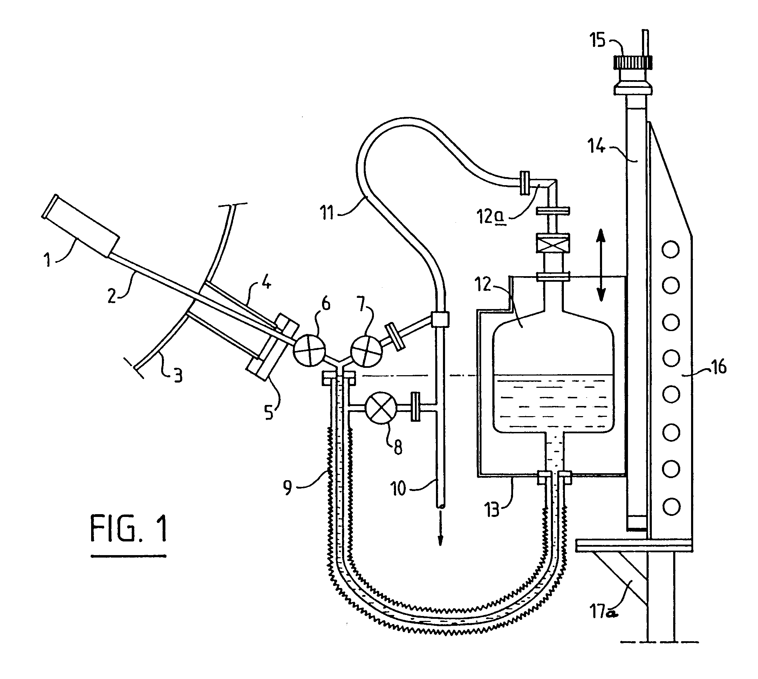

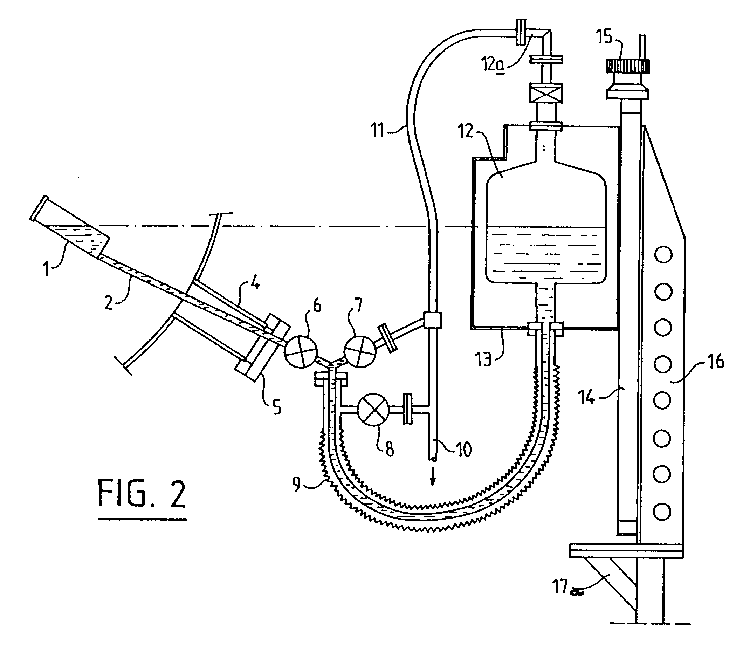

Sur les dessins, et notamment sur les figures 1 et 2, le dispositif d'alimentation en mercure de l'invention se compose d'un dispositif d'évaporation du mercure ou cellule d'évaporation 1 où ladite évaporation du mercure qui est un métal liquide, s'effectue par effet Joule. Cette cellule est disposée à l'intérieur d'une chambre de croissance dite MBE (Molecular Beam Epitaxy) dont l'enceinte 3 présente une bride ou piquage 4 à travers lequel la cellule 1 est alimentée par un tuyau 2 traversant l'obturateur 5 du piquage et se raccordant à une vanne 6 commandant conjointement avec les vannes 7 et 8 l'alimentation de la cellule 1 par l'intermédiaire d'un tuyau 9, avantageusement en Téflon, relié à un réservoir 12 dont le raccord 12a est relié par un flexible 11 d'une part à ladite vanne 7, et d'autre part, à un flexible 10 raccordé à une unité de pompage. Comme représenté plus particulièrement sur la figure 1, le réservoir 12 est monté sur un support 13 déplaçable en translation verticale le long d'un montant 14 par l'intermédiaire d'un dispositif à crémaillère 16 monté sur une potence 17a et actionné manuellement en 15 ou par l'intermédiaire de moyens moteurs non représentés aux dessins.

Comme représenté sur la figure 2, le réservoir a été déplacé vers le haut de façon à permettre le transfert du mercure du réservoir 12 vers la cellule 1 via le conduit d'alimentation 9, la vanne 6 et le tuyau 2, les vannes 7 et 8 étant fermées, ce qui fait que la mise à niveau est réalisée par le principe des vases communiquants. Le réservoir 12 permet d'évaporation de 15 kg de mercure sans ouverture du bâti d'évaporation et sans rechargement du réservoir. Il assure en outre un niveau constant d'évaporation pendant la croissance d'une couche épitaxiale. Ceci est dû au rapport des surfaces du mercure dans le réservoir extérieur et dans la partie évaporateur de la cellule d'évaporation 1. Le réservoir 12 permet également le remplissage de la cellule d'évaporation pour la croissance, comme représenté sur la figure 2, et le vidage de la cellule de croissance, en position basse du réservoir 12 comme représenté sur la figure 1, le tout étant effectué par des déplacements translationnels verticaux appropriés du réservoir 12.

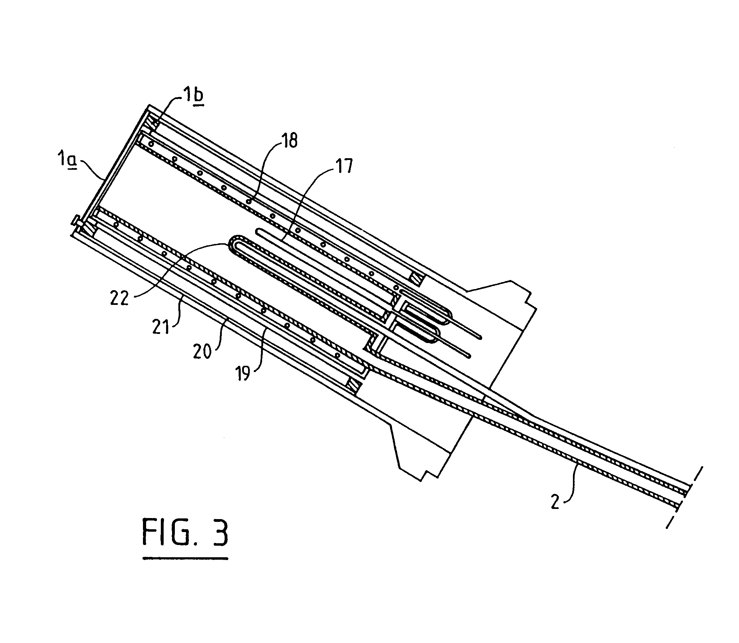

Comme représenté sur la figure 3, la cellule d'évaporation 1 est pour vue d'un chapeau diffuseur 1a maintenu par un dispositif à bague 1b et enveloppé latéralement par une série de trois écrans, à savoir un écran externe 21, un écran interne 19 et un écran intermédiaire 20 au voisinage immédiat de l'écran externe 21. Cette cellule est pourvue d'un thermo-couple 22 et d'un dispositif de chauffage par effet Joule constitué d'un filament périphérique 18 contrôlé par ledit thermo-couple dont la partie sensible est située au voisinage immédiat de la zone d'évaporation du mercure dans la cellule. On a également prévu un détecteur ou sonde de niveau 17 constitué par un capteur dont le signal permettra après amplification soit de prévenir l'opérateur qui pourra intervenir de façon manuelle, soit être traité par des moyens électro-informatiques, non représentés aux dessins, destinés à déclencher les moyens moteurs, non représentés aux dessins de façon que ces derniers agissent sur la crémaillère de façon à positionner le réservoir 12 à un niveau permettant par le principe des vases communiquants, de remplir la cellule 1 au niveau désiré.

La sonde 17 est un contact électrique entre un fil placé dans le réservoir de la cellule d'évaporation et la masse du mercure liquide dans ce réservoir. Ainsi, en détectant ce niveau et émettant un signal correspondant, il est possible d'amener le mercure toujours au même niveau dans la cellule d'évaporation.

Ce dispositif est particulièrement destiné à la croissance cristalline des semi-conducteurs sous vide et notamment à la croissance épitaxiale des semi-conducteurs II-VI à base de mercure.

Il est clair que la présente invention n'est nullement limitée à la forme de réalisation décrite ci-dessus, en référence aux dessins annexés, mais qu'elle englobe toutes les modifications des variantes issues du même principe de base. C'est ainsi que si des références numériques ont été apportées dans les revendications, elles ne peuvent servir que de points de repère pour une meilleure compréhension de l'invention, mais ne sauraient limiter cette dernière en aucune façon.

## Revendications

1. Dispositif de croissance épitaxiale par jet moléculaire, comprenant une cellule (1) d'évaporation de mercure dans un bâti de croissance (3) sous vide et un dispositif d'alimentation de ladite cellule (1), ledit dispositif d'alimentation comportant lui-même :
- un réservoir (12) d'alimentation en mercure,
- un tube (9) d'alimentation de ladite cellule (1) à partir dudit réservoir (12), et
- des moyens (6, 7, 8) de remplissage, de mise à niveau et de vidange de mercure dans ladite cellule (1), caractérisé en ce que lesdits moyens de remplissage, mise à niveau et vidange permettent le déplacement en translation verticale dudit réservoir (12), ledit déplacement étant réalisé manuellement ou par l'intermédiaire de moyens moteurs, et lesdits moyens comprennent, au niveau de la liaison entre ladite cellule (1) et ledit réservoir d'alimentation (12), un agencement de vannes (6, 7, 8) permettant :
-- de couper la communication entre ledit réservoir (12) et ladite cellule (1) pour le remplissage dudit réservoir (12),
-- d'équilibrer les pressions entre ledit réservoir (12) et ledit bâti de croissance (3) de ladite cellule (1) qui est toujours sous vide, et
-- d'évacuer l'air de l'espace entre ledit tube d'alimentation (9) de ladite cellule (1) et un soufflet de protection dudit tube (9).

2. Dispositif selon la revendication 1, caractérisé en ce que ladite cellule d'évaporation (1) comprend une sonde de niveau de mercure (17) susceptible d'émettre un signal permettant de déclencher la mise en fonctionnement desdits moyens moteurs, en vue de permettre la remise à niveau de la cellule (1).

3. Dispositif selon la revendication 2, caractérisé en ce que ladite cellule d'évaporation (1) comporte une sonde de température disposée au voisinage immédiat du niveau d'évaporation du mercure.

4. Dispositif selon l'une des revendications 1 à 3, caractérisé en ce que ledit réservoir (12) est monté sur des moyens supports (13, 14) permettant audit réservoir (12) d'occuper diverses positions assurant un remplissage à niveau constant de ladite cellule (1).

## Claims

1. Device for epitaxial growth using a molecular stream, comprising a mercury evaporation cell (1) in a growth structure (3) under vacuum and a device for feeding the said cell (1), said feeding device itself comprising:
- a mercury feed storage vessel (12),
- a feed tube (9) feeding the said cell (1) from the said storage vessel (12), and
- means (6, 7, 8) permitting the filling, the level setting and the draining of the mercury in the said cell (1), characterized in that the said means permitting the filling, level setting and draining allow the vertical translation movement of the said storage vessel (12), the said movement being performed manually or by means of driving means, and the said means including, at the level of the connection between the cell (1) and the said feed storage vessel (12), a valve arrangement making it possible to:
-- cut the communication between the said storage vessel (12) and the cell (1) for filling the said storage vessel (12),
-- balance the pressures between the said storage vessel (12) and the said growth structure (3) of the said cell (1) which is always under vacuum, and
-- evacuate the air from the space between the said feed tube (9) of the said cell (1) and the protective bellows of the said tube (9).

2. Device according to claim 1, characterized in that the evaporation cell (1) comprises a mercury level probe (17) capable of emitting a signal making it possible to trigger the startup of the said driving means so as to permit resetting of the level in the cell (1).

3. Device according to claim 2, characterized in that the said evaporation cell (1) comprises a temperature probe arranged in the immediate neighbourhood of the mercury evaporation level.

4. Device according to any one of claims 1 to 3, characterized in that the said storage vessel (12) is mounted on supporting means (13, 14) allowing the said storage vessel (12) to occupy various positions ensuring the filling of the said cell (1) to a constant level.

## Patentansprüche

1. Vorrichtung zum epitaxialem Wachsen mit Hilfe eines Molekularstroms mit einer Quecksilber-Verdampfungszelle (1), die in einer unter Vakuum befindlichen Wachstumskammer (3) angeordnet ist, und mit einer Versorgungseinrichtung für die Zelle (1), die ihrerseits enthält:
- ein Vorratsgefäß (12) für die Versorgung mit Quecksilber,
- ein Rohr (9) für die Versorgung der Zelle (1) aus dem Vorratsgefäß (12), und
- Mittel (6,7,8) zum Füllen, Niveaueinstellen und Leeren des Quecksilbers aus der, in der, bzw. in die Zelle (1),
**dadurch gekennzeichnet,**
daß die Mittel zum Füllen, Niveaueinstellen und Leeren eine vertikale Translationsbewegung des Vorratsgefäßes (12) ermöglichen, wobei die Bewegung von Hand oder motorisch erfolgt, und daß die Mittel in Bezug auf die Verbindung zwischen der Zelle (1) und dem Vorratsgefäß (12) eine Ventileinrichtung (6,7,8) aufweisen, die folgendes ermöglicht:
- eine Unterbrechung der Verbindung zwischen dem Vorratsgefäß (12) und der Zelle (1), um das Vorratsgefäß zu füllen,
- einen Druckausgleich zwischen dem Vorratsgefäß (12) und der Wachstumskammer (3) der Zelle (1), die immer noch an Vakuum liegt, und
- ein Evakuieren der Luft aus dem Raum zwischen dem Versorgungsrohr (9) der Zelle (1) und einem Balg für den Schutz des Rohres (9).

2. Vorrichtung nach Anspruch 1,
**dadurch gekennzeichnet,**
daß die Verdampfungszelle (1) eine Sonde (17) für das Niveau des Quecksilbers aufweist, die ein Signal abgeben kann, das die motorischen Mittel auslösen kann, um das Niveau der Zelle (1) wieder herzustellen.

3. Vorrichtung nach Anspruch 2,
**dadurch gekennzeichnet,**
daß die Verdampfungszelle (1) eine Temperatursonde aufweist, die unmittelbar dem Verdampfungsniveau des Quecksilbers benachbart angeordnet ist.

4. Vorrichtung nach einem der Ansprüche 1 bis 3,
**dadurch gekennzeichnet,**
daß das Vorratsgefäß (12) auf einer Stütze (13,14) befestigt ist, die es ermöglicht, daß das Vorratsgefäß (12) verschiedene Positionen einnimmt, die ein Füllen der Zelle (1) auf ein konstantes Niveau sicherstellen.
